Europäisches Patentamt

European Patent Office

Office européen des brevets

(11) Veröffentlichungsnummer: **0 255 554 B1**

# EUROPÄISCHE PATENTSCHRIFT

(45) Veröffentlichungstag der Patentschrift: **08.05.91**

(51) Int. Cl.⁵: **H03H 17/06**

(21) Anmeldenummer: **86110932.0**

(22) Anmeldetag: **07.08.86**

(54) **Nichtrekursives Digitalfilter.**

(43) Veröffentlichungstag der Anmeldung:
**10.02.88 Patentblatt 88/06**

(45) Bekanntmachung des Hinweises auf die
Patenterteilung:
**08.05.91 Patentblatt 91/19**

(84) Benannte Vertragsstaaten:
**DE FR NL**

(56) Entgegenhaltungen:
**EP-A- 0 105 998**

**PATENTS ABSTRACTS OF JAPAN, Band 9,
Nr. 131 (E-319)[1854], 6. Juni 1985; & JP-A-60
16 715 (NIPPON DENSHIN DENWA KOSHA)**

**INTERNATIONAL JOURNAL OF ELECTRO-
NICS, Band 55, Nr. 4, Oktober 1983, Seiten
675-679, Basingstoke, Hampshire, GB; A.N.
SKODRAS: "On the use of look-up tables in
the microprocessor implementation of digital filters"**

(73) Patentinhaber: **Deutsche ITT Industries GmbH
Hans-Bunte-Strasse 19 Postfach 840
W-7800 Freiburg i.Br.(DE)**

(72) Erfinder: **Mehrgardt, Sönke, Dr.
Häglestrasse 26
W-7801 March(DE)**
Erfinder: **Ehret, Bernhard, Dipl.-Ing.
Im Glaser 25
W-7800 Freiburg i.Br.(DE)**

## Beschreibung

Die Erfindung betrifft ein nichtrekursives Digitalfilter mit einer im Signalweg liegenden Serienschaltung einer Anzahl von gleichen Verzögerern, deren Verzögerungszeit gleich der Periodendauer des Taktsignals des Digitalfilters oder gleich einem Vielfachen davon ist, und mit einem Addierer, dessen Ausgang der Filterausgang ist, vgl. den Oberbegriff des Anspruchs 1.

Ein derartiges Digitalfilter ist in der veröffentlichten Patentanmeldung EP-A-0105 998 dem Prinzip nach beschrieben, wobei allerdings lediglich ein beliebiger Abgriff der Verzögerer und deren bezüglich von deren Mittelpunkt spiegelbildlich gelegene Abgriffe sowie der Ausgang eine Konstantenmultiplizierers auf die Eingänge des Addierers geschaltet sind, wobei der Eingang des Konstantenmultiplizierers mit dem Mittelpunkt der Serienschaltung verbunden ist. Diese vorbeschriebene Anordnung dient als Digitalfilter für den digital arbeitenden Luminanzkanal von Farbfernsehgeräten.

Der in den Ansprüchen gekennzeichneten Erfindung liegt demgegenüber die Aufgabe zugrunde, ein nichtrekursives Digitalfilter anzugeben, das zur Unterdrückung von Rauschen bei digitalen Signalen, insbesondere bei Videosignalen, geeignet ist.

Die Erfindung wird nun anhand der Figuren der Zeichnung näher erläutert.

Fig. 1 zeigt in schematischer Digitalfilter-Blockschaltbild-Darstellungsweise das der Erfindung zugrundeliegende Prinzip,

Fig. 2 zeigt eine Vereinfachung der Anordnung nach Fig. 1 für einen speziellen Anwendungsfall.

Fig. 3 zeigt schematisch eine mögliche Abhängigkeit der in den Festwertspeichern abgelegten Funktion,

Fig. 4 zeigt ein spezielles Ausführungsbeispiel der Erfindung mit Multiplex-Betrieb einzelner Filterteilschaltungen,

Fig. 5 zeigt verschiedene Kurvenformen von bei der Anordnung nach Fig. 4 benötigten und auftretenden Signalen,

Fig. 6 zeigt in Form einer ersten Tabelle die zeitliche Zuordnung einzelner Eingangssignale der Fig. 4,

Fig. 7 zeigt in Form einer zweiten Tabelle Definitionen für in Fig. 4 auftretende Signale von Teilresultaten, und

Fig. 8 zeigt in Form einer dritten Tabelle die zeitliche Zuordnung von Signalen der ersten und der zweiten Tabelle sowie weiterer Teilresultate und eines Endresultats.

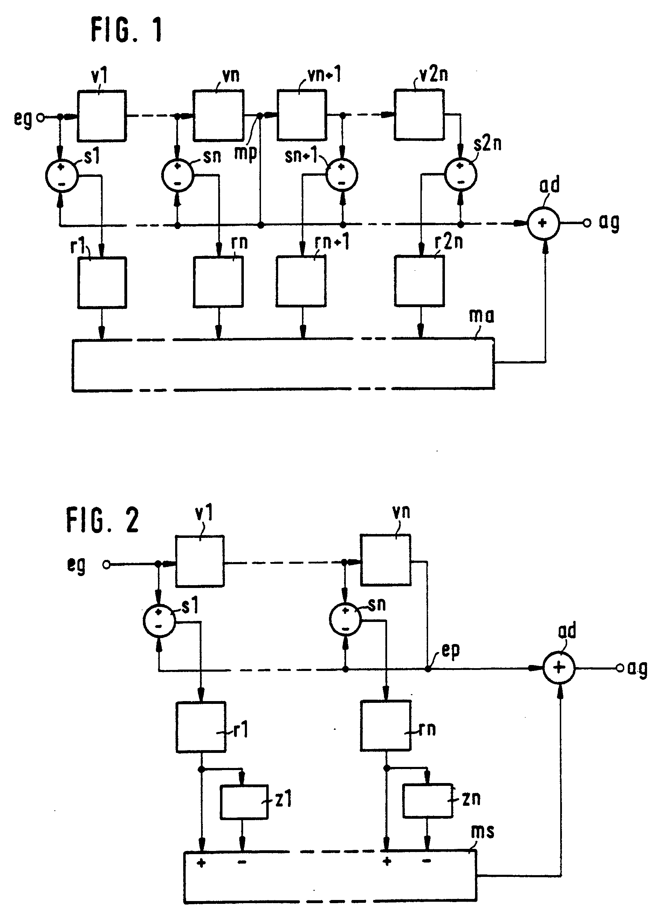

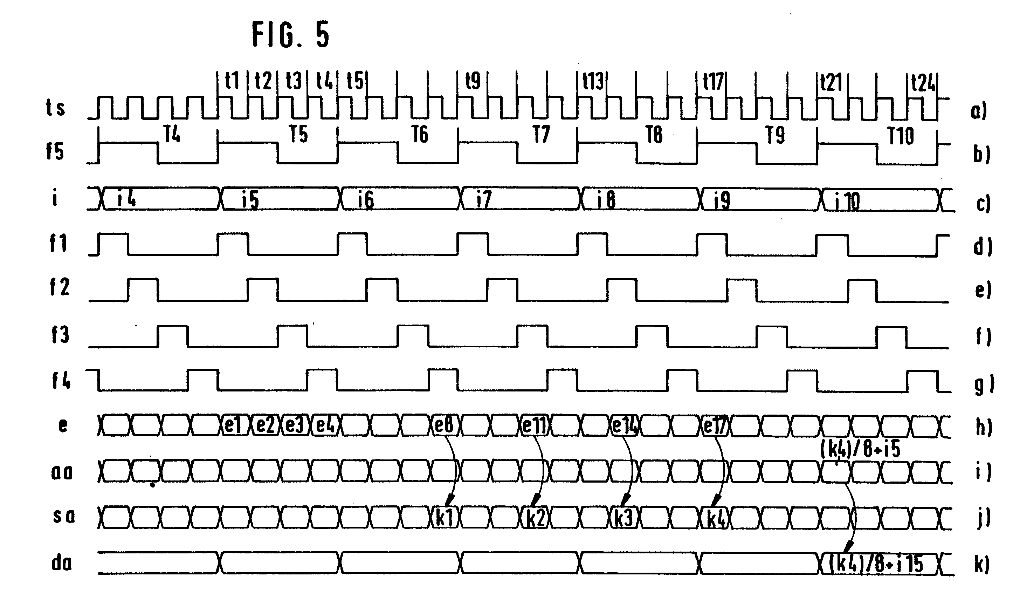

Die Fig. 1 zeigt in der für die schaltbildmäßige Darstellung von Digitalfiltern üblichen Art und Weise das Blockschaltbild eines Ausführungsbeispiels des Digitalfilters der Erfindung. Dabei liegt im Signalweg der gerade Anzahl 2n der gleichen Verzögerer v1, vn, vn + 1, v2n. Der Eingang eg des Digitalfilters liegt somit am Eingang des ersten Verzögerers v1. Die Verzögerungszeit dieser Verzögerer ist jeweils gleich der Periodendauer des Taktsignals ts des Digitalfilters oder einem Vielfachen davon (vg. Fig. 5a).

Jedem Verzögerer ist ein Subtrahierer und ein Festwertspeicher zugeordnet, wobei der jeweilige Minuend-Eingang der Subtrahierer am Eingang des zugeordneten Verzögerers der ersten Hälfte der Verzögerer v1, vn bzw. am Ausgang des zugeordneten Verzögerers der zweiten Hälfte der Verzögerer vn + 1, v2n angeschlossen ist. Zum Verzögerer v1 bzw. vn bzw. vn + 1 bzw. v2n gehört also der Subtrahierer s1 bzw. sn bzw. sn + 1 bzw. s2n und der Festwertspeicher r1 bzw. rn bzw. rn + 1, bzw. r2n. Der Subtrahend-Eingang aller Subtrahierer s1...s2n ist gemeinsam mit dem Mittelpunkt mp der Verzögerer-Serienschaltung und mit dem ersten Eingang des Addierer ad verbunden, dessen Ausgang der Filterausgang ag ist. Der jeweilige Ausgang der Subtrahierer liegt am Adreßeingang des zugeordneten Festwertspeichers.

In jedem Festwertspeicher ist die Funktion $e = bd$ gespeichert, wobei mit d das Ausgangssignal des zugehörigen Subtahierers und mit b ein von der Differenz zwischen dem Signalwert am Mittelpunkt mp und dem Eingangssignalwert des jeweiligen Verzögerers der ersten Hälfte bzw. dem Ausgangssignalwert des jeweiligen Verzögerers der zweiten Hälfte der Verzögerer abhängiger Wert bezeichnet ist. Der jeweilige Ausgang der Festwertspeicher ist mit einem entsprechenden Eingang des Mehrfachaddierers ma verbunden, dessen Ausgang am zweiten Eingang des Addierers ad liegt.

Beim erfindungsgemäßen Digitalfilter durchlaufen die am Eingang eg ankommenden Digitalworte die Serienschaltung der Verzögerer, so daß zu dem zu einem betrachteten Zeitpunkt am Mittelpunkt mp auftretenden Digitalwort auch die um jeweils n Periodendauern des Taktsignals sowohl vorausgehenden als auch nachfolgenden Digitalworte gleichzeitig zur Verfügung stehen. Die Subtrahierer bilden daher die Differenz zwischen diesen einzelnen Digitalworten und dem Mittelpunkt-Digitalwort. In Abhängigkeit von dieser Differenz tritt am Ausgang der Festwertspeicher der zugehörige Funktionswert $e = bd$ auf, welche Funktionswerte dann mittels des Mehrfachaddierers ma summiert und zum Mittelpunkt-Digitalwort addiert werden. Das Digitalfilter zeigt somit eine gewisse Form von adaptivem Verhalten.

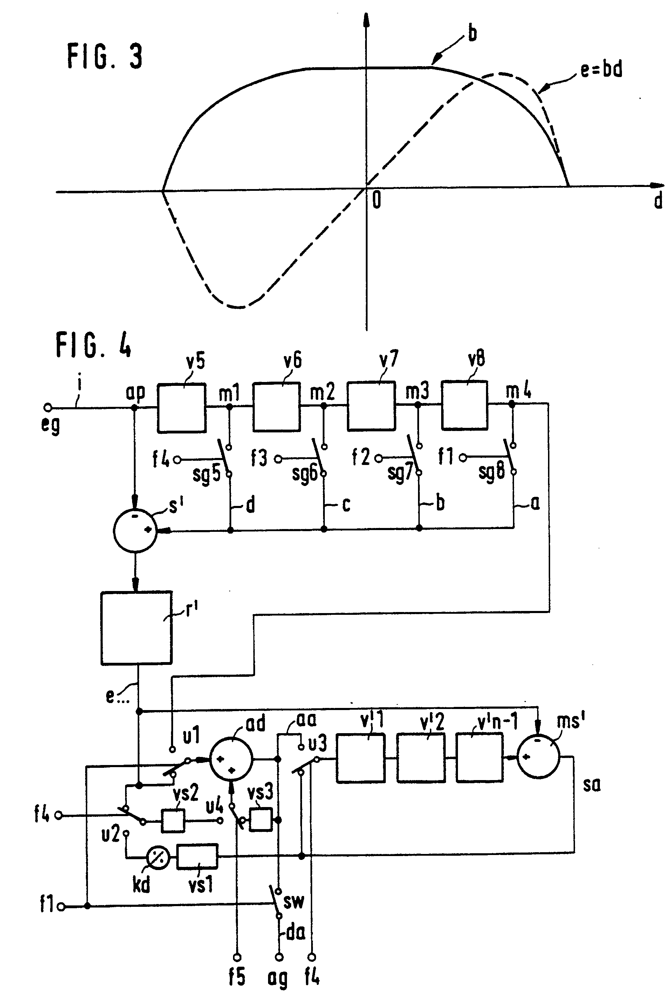

Die Fig. 3 zeigt einen möglichen qualitativen Verlauf der Funktionen b und $e = bd$ in Abhängigkeit vom Wert d.

Die Fig. 2 zeigt in gleicher Weise blockschaltbildartig wie Fig. 1 eine Abwandlung des darin gezeigten Digitalfilters für den Fall, daß die erste Hälfte der Festwertspeicher r1, rn spiegelsymmetrisch zur zweiten Hälfte rn + 1, r2n ist, und zwar in dem Sinne, daß der Inhalt eines m-ten Festwertspeichers der ersten Hälfte auf einer Adresse adr gleich dem negativen Inhalt des (2n + 1-m)ten Festwertspeicher der zweiten Hälfte auf der Adresse -adr ist, wobei m kleiner/gleich n ist. Bei z.B. zehn Verzögerern sind also der erste und der zehnte (m = 1), der zweite und der neunte (m = 2) etc. jeweils spiegelsymmetrisch zueinander. Für solche Fälle kann auf die jeweils zweite Hälfte der Verzögerer vn + 1, v2n, Subtrahierer sn + 1, s2n und Festwertspeicher rn + 1, r2n verzichtet werden, so daß bei der Anordnung von Fig. 2 der dem Mittelpunkt mp von Fig. 1 entsprechende Schaltungspunkt zum Endpunkt ep der Serienschaltung von Verzögerern wird.

Jedem verbliebenen Festwertspeicher r1, rn ist jeweils der Zusatzverzögerer z1, zn zugeordnet, dessen Eingang am Ausgang des jeweiligen Festwertspeichers r1, rn liegt. Die Verzögerungszeit des signaleingangsseitigen Zusatzverzögerers r1 ist das n-fache der Periodendauer des Taktsignals, die des folgenden Zusatzverzögerers das (n-1)-fache der Periodendauer etc., wobei n die verbliebene Anzahl der Verzögerer v1, vn ist. Die Verzögerungszeit des letzten Zusatzverzögerers zn ist somit gleich der Periodendauer des Taktsignals ts.

Der Mehrfachaddierer ma nach Fig. 1 ist bei der Abwandlung nach Fig. 2 dadurch als Mehrfachaddierer/subtrahierer ms ausgebildet, daß die den entfallenen Festwertspeichern rn + 1, r2n nach Fig. 1 zugeordneten Addend-Eingänge in Subtrahend-Eingänge umgewandelt sind, wie dies durch das entsprechende Minuszeichen angedeutet ist.

Die Fig. 4 zeigt eine Ausgestaltung der Erfindung für den Fall der oben erwähnten Spiegelsymmetrie der Festwertspeicher und daß zusätzlich die Datenrate der zu filternden Digitalsignale gleich dem n-ten Teil der Frequenz des Taktsignals ts ist; unter Datenrate wird dabei die Frequenz desjenigen Takts bezeichnet, mit dem die Digitalsignale dem Eingang eg des Digitalfilters zugeführt sind. Im konkreten Fall der Fig. 4 ist n = 4 gewählt.

Bei Fig. 4 wird im Gegensatz zur Anordnung nach Fig. 2 auf jeweils die erste Hälfte der Verzögerer v1, vn, Subtrahierer s1, sn und Festwertspeicher r1, rn verzichtet, so daß der dem Mittelpunkt mp nach Fig. 1 entsprechende Schaltungspunkt in Fig. 4 der Anfangspunkt ap ist. Die verbleibenden Verzögerer v5, v6, v7, v8 sind solche der zweiten Hälfte, und ihre Verzögerungszeit ist gleich der n-fachen, also vierfachen, Periodendauer des Taktsignals ts; ein entsprechendes Hilfstaktsignal zeigt Fig. 5b.

Von den eigentlich jeweils n Subtrahierern und Festwertspeichern sind nur der Subtrahierer s', der Festwertspeicher r' und anstatt des Mehrfachaddierer/subtrahierers ms der weitere Subtrahierer ms' vorhanden, die innerhalb der Periodendauer der Datenrate zeitlich nacheinander n mal, also viermal, benutzt sind. Dabei wirkt der Addierer ad mit dem Subtrahierer ms' während n-1, also drei, Periodendauern des Taktsignals als Mehrfachaddierer/subtrahierer zusammen.

Der jeweilige Ausgang der Verzögerer v5...v8 liegt am Minuend-Eingang des Subtrahierers s', und zwar über das jeweilige Schaltglied sg5, sg6, sg7, sg8, dessen jeweiligem Steuereingang das n-te, also vierte, bzw. das (n-1)te, also dritte, bzw. zweite bzw. erste Hilfstaktsignal f4, f3, f2, f1 zugeführt ist. Die Frequenz dieser Hilfstaktsignale ist gleich dem n-ten, also vierten, Teil der Frequenz der Taktsignals ts, und deren Impulsbreite ist gleich der Periodendauer des Taktsignals, wobei die wirksamen Impulse der einzelnen Hilfstaktsignale um diese Periodendauer gegeneinander versetzt mit steigender Indexzahl aufeinanderfolgen, vgl. Fig. 5d bis Fig. 5g. Während des H-Pegels der wirksamen Impulse der Hilfstaktsignale f1...f4 ist das jeweilige Schaltglied sg5...sg8 leitend gesteuert.

Der Ausgang des Festwertspeichers r' liegt nicht nur am Subtrahend-Eingang des Subtrahierers ms', sondern auch am jeweils ersten Eingang des ersten und des zweiten Umschalters u1, u2. Der Ausgang des letzten Verzögerers v8 liegt am zweiten Eingang des ersten Umschalters u1, dessen Ausgang mit dem ersten Eingang des Addierers ad verbunden ist.

Der Ausgang des Addierers ad liegt am ersten Eingang des dritten Umschalters u3, dessen Ausgang mit dem Eingang der Serienschaltung von n-1, also drei, weiteren Verzögerern v'1, v'2, v'n-1 verbunden ist, und erst über das weitere Schaltglied sw am Ausgang ag des Digitalfilters. Dem Steuereingang des Schaltglieds sw ist das erste Hilfstaktsignal f1 zugeführt.

Der Ausgang des letzten weiteren Verzögerers v' n-1 liegt am Minuend-Eingang des Subtrahierers ms', dessen Ausgang am zweiten Eingang des dritten Umschalters u3 angeschlossen ist. Diese zweite Eingang liegt ferner in dieser Reihenfolge über die erste Verzögerungsstufe vs1 und den Konstantendividierer kd am zweiten Eingang des zweiten Umschalters us2, dessen Ausgang über die zweite Verzögerungsstufe vs2 mit dem ersten Eingang des vierten Umschalters u4 verbunden ist. Dessen zweiter Eingang bzw. dessen Ausgang ist über die dritte Verzögerungsstufe vs3 mit dem Ausgang bzw. mit dem zweiten Eingang des Addierers ad verbunden.

Die Verzögerungszeit der ersten Verzögerungsstufe vs1 ist gleich der (n-1)fachen, also dreifachen, Periodendauer des Taktsignals ts. Die jeweilige Verzögerungszeit der zweiten und dritten Verzögerungsstufe vs2, vs3 sowie der n-1 weiteren Verzögerungsstufen v'1...v'n-1 ist gleich der Periodendauer des Taktsignals ts. Mit dem Konstantendividierer kd wird eine Stellenreduktion der am Ausgang der ersten Verzögerungsstufe vs1 auftretenden Digitalwörter auf die am Eingang der zweiten Verzögerungsstufe vs2 vom Ausgang des Festwertspeichers r' vorgegebene Stellenzahl erreicht. Bei einer konkreten Schaltung wurde dem Konstantendividierer kd ein der Dezimalzahl 8 entsprechendes Digitalwort als Divisionskonstante zugeführt.

Dem jeweiligen Steuereingang des ersten und des zweiten Umschalters u1, u2 ist das erste Hilfstaktsignal f1 und dem des dritten Umschalters u3 das n-te, also vierte, Hilfstaktsignal f4 zugeführt. Am Steuereingang des vierten Umschalters u4 liegt das weitere Hilfstaktsignal f5, das das Puls-Pausen-Verhältnis 1:1 und eine Frequenz hat, die gleich dem n-ten, also vierten, Teil der Frequenz des Taktsignals ts ist.

Die in Fig. 4 gezeigte jeweilige Schalterstellung der Umschalter u1...u4 ist diejenige, in der sie sich befinden, wenn die Hilfstaktsignale f1, f4, f5 ihren L-Pegel aufweisen. Oder mit anderen Worten ausgedrückt ist während des jeweiligen H-Pegels der Hilfstaktsignale f1, f4, f5 der jeweilige Ausgang beim ersten, dritten und vierten Umschalter u1, u3, u4 mit seinem ersten Eingang, beim zweiten Umschalter u2 mit seinem zweiten Eingang und beim weiteren Schaltglied sw mit seinem Eingang durchverbunden.

Bei der Anordnung nach Fig. 4 wird durch die Taktung mittels der fünf Hilfstaktsignale f1...f5 ein Multiplexbetrieb erreicht, der durch die damit verbundene Mehrfachausnutzung von einzelnen Schaltungsteilen eine erhebliche Reduzierung der zur Realisierung des Digitalfilters als integrierte Schaltung erforderlichen Kristallfläche im Vergleich zu einer Realisierung ohne Multiplexung ergibt.

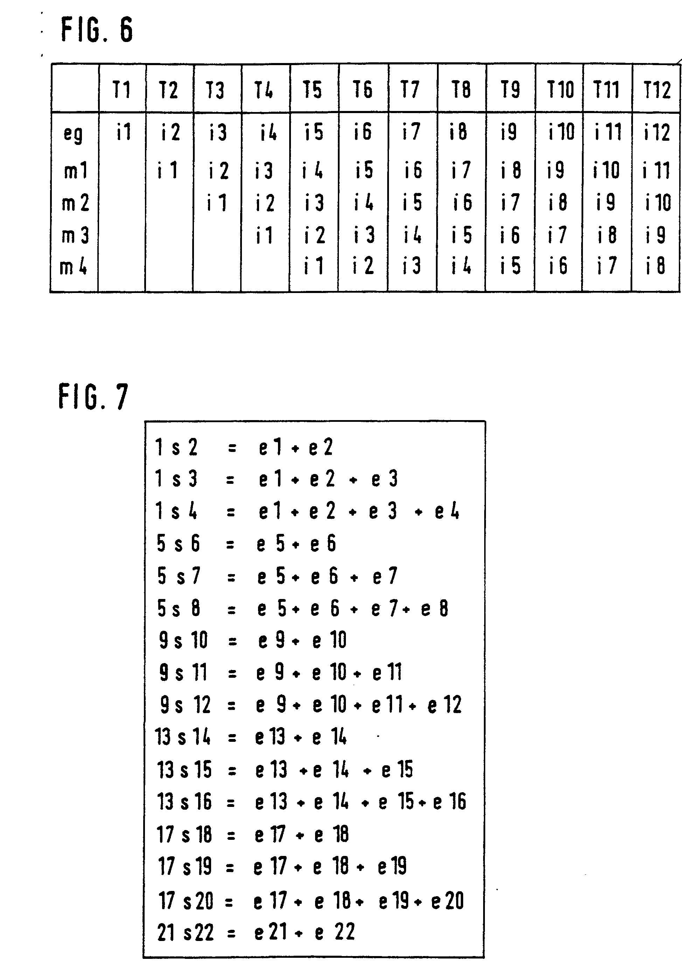

Die Fig. 5 zeigt schematisch den zeitlichen Verlauf der bei der Ausgestaltung nach Fig. 4 benutzten Taktsignale sowie die zeitliche Lage einzelner Berechnungsresultate bezüglich konkreter Periodendauern der Hilfstaktsignale. Zum Verständnis der Fig. 5 sind die Tabellen der Fig. 6 bis 8 heranzuziehen. Diese Tabellen sind Bestandteil der Beschriebung. Aus ihnen ergibt sich die zeitliche Zuordnung und Reihenfolge der einzelnen Berechnungsschritte. Bei der folgenden rein beispielsweisen Erläuterung der Funktion für ein einzelnes Endresultat werden daher die Fig. 5 bis 8 gemeinsam betrachtet. Für diese Funktionserläuterung wird vorausgesetzt, daß die Rechenzeit der Addierer und Subtrahierer sowie die Auslesezeit aus dem Festwertspeicher klein ist im Vergleich zur Periodendauer des Taktsignals, also vernachlässigbar ist.

In Fig. 5a bzw. b sind für das Taktsignal ts bzw. das Hilfstaktsignal f5 aufeinanderfolgende "kurze" bzw. "lange" Periodendauern definiert, die mit t bzw. T bezeichnet und fortlaufend numeriert sind. Zur Vereinfachung ist vorausgesetzt, daß entsprechend der Tabelle nach Fig. 6 das Digitalfilter zur Periodendauer T1 des Hilfstaktsignals f5 zu arbeiten beginnt und daß während der zwölf Periodendauern T1...T12 die zwölf Digitalwörter i1...i12 nacheinander am Eingang eg auftreten. Am jeweiligen Ausgang m1...m4 der vier Verzögerer v5...v8 erscheinen dann die einzelnen Digitalwörter i1...i12 nach jeweils einer Periodendauer des Hilfstaktsignals f5. Somit ergibt sich die Matrix von Digitalworten, wie sie in der Tabelle der Fig. 6 dargestellt ist, bei der sich mit steigender Zeilenzahl die Reihe der Digitalwörter i1...i12 jeweils um eine Spalte nach rechts verschiebt.

In Fig. 5 sind von den langen Periodendauern T1...T12 die Periodendauern T4...T10 gezeigt; die Berechnung des betrachteten Endresultats erfolgt dabei während der Periodendauern T5...T9, und Beginn der Periodendauer T10 erreicht das Endresultat den Ausgang ag, vgl. Fig. 5K.

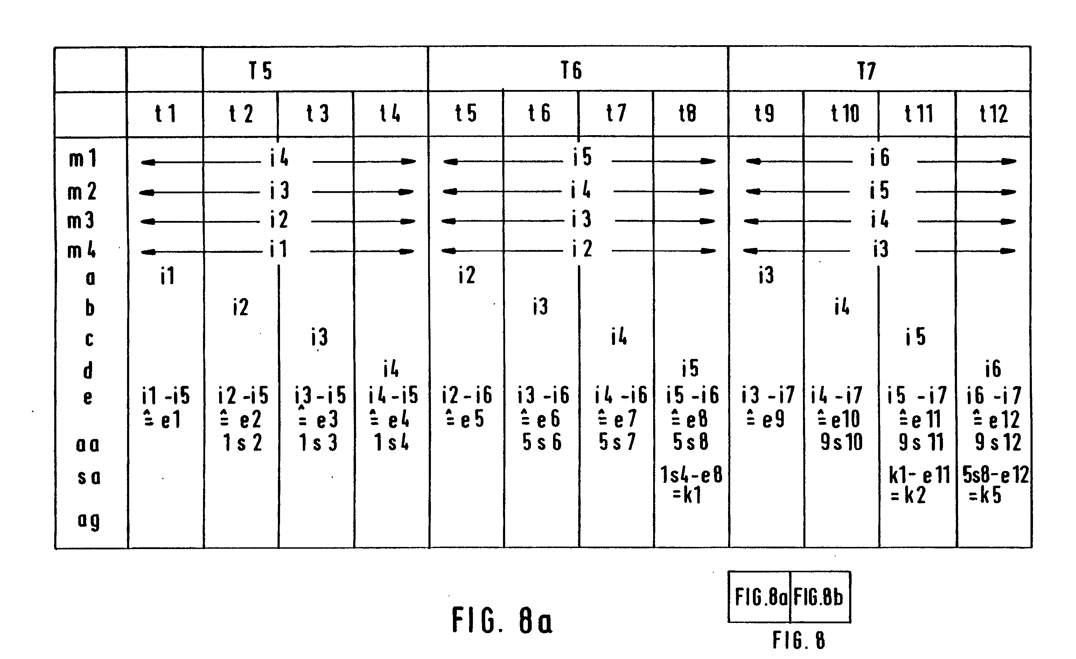

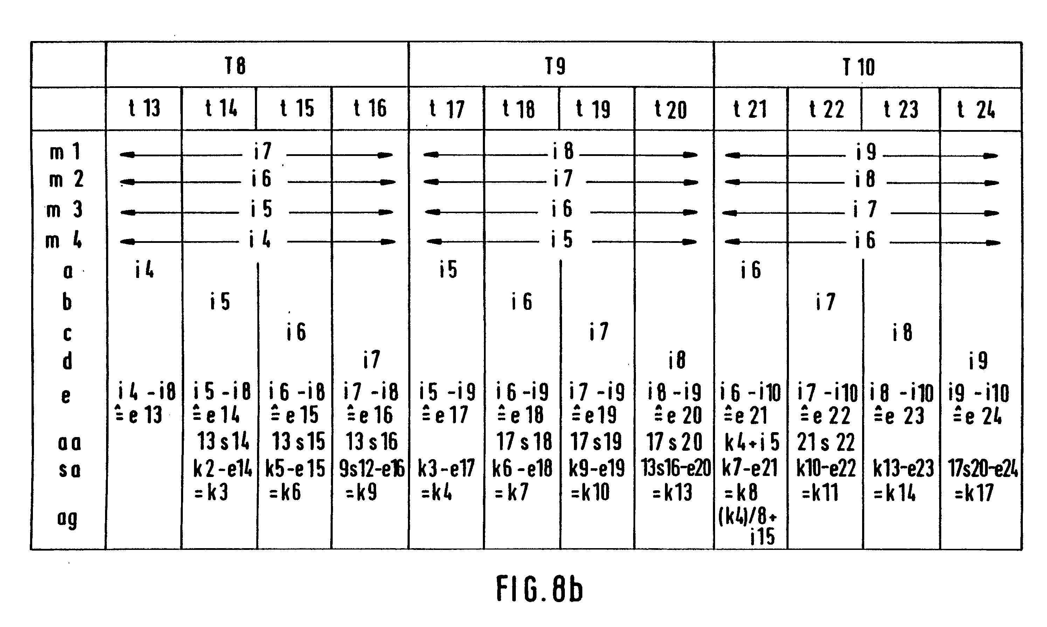

Die während dieser sechs Periodendauern auftretenden kurzen Periodendauern des Taktsignals ts sind, beginnend mit der Periodendauer T5, fortlaufend mit t1...t24 bezeichnet, vgl. Fig. 5a und 8.

Entsprechend Fig. 8a steht am Ausgang des Verzögerers v5 während der Periodendauer T5, also auch während der vier Periodendauern t1...t4, das Digitalwort i4. Dieses Digitalwort i4 liegt während der Periodendauer T6 am Ausgang m2, während T7 an m3 und während T8 an m4, so daß die Wanderung des Digitalworts i4 durch die Serienschaltung der Verzögerer v5...v8 somit beschrieben ist. Andererseits liegt am Ausgang m1 des Verzögerers v5 während der Periodendauer T5 das Digitalwort i4, während T6 das Digitalwort i5, während T7 das Digitalwort i6, während T8 das Digitalwort i7, während T9 das Digitalwort i8 und während T10 das Digitalwort i9. Entsprechendes gilt für die Ausgänge m2...m4, an denen während der Periodendauern T5...T10 die Digitalwörter i3...i8 bzw. i2...i7 bzw. i1...i6 auftreten.

Da während der langen Periodendauer T5 am Eingang eg und somit auch am Subtrahend-Eingang des Subtrahierers s' das Digitalwort i5 liegt, werden während der vier kurzen Periodendauern t1...t4 nacheinander die Differenzen zwischen den Digitalwörtern i1...i4 und i5 gebildet, die am Ausgang des Festwertspeichers r' die Ausgangssignale e... erzeugen, die nach Fig. 8a mit e1...e4 bezeichnet sind. In gleicher Weise werden während der langen Periodendauern T6...T10 die Ausgangssignale e5...e24 vom Festwertspeicher r' erzeugt, die wiederum, wie in Fig. 8a und b, Zeile e angegeben, den jeweiligen Differenzen entsprechen. In Fig 5h sind einige der Digitalwörter e1...e24 eingezeichnet.

Während jeder zweiten bis vierten Periodendauer des Taktsignals ts innerhalb einer Periodendauer des Hilfstaktsignals f5, also z.B. während der Periodendauern t2...t4, t6...t8 wirkt der Addierer ad als Akkumulator für die jeweils vier Differenzen e1...e4 bze. e5...e8 etc., wobei für das Ergebnis der jeweiligen Akkumulation die in Fig. 8a und b, Zeile aa eingetragenen Bezugszeichen gewählt sind, deren Definition die Tabelle der Fig. 7 zeigt. Die Systematik dieser Bezugszeichen besteht darin, daß vor dem Buchstaben s diejenige Laufzahl der Differenzen e... steht, die während der ersten kurzen Periodendauer innerhalb einer langen Periodendauer, also während t1, t5, t9 etc., auftritt, und daß hinter dem Buchstaben s die Laufzahl der letzten, innerhalb einer langen Periodendauer aufakkumulierten Differenzen steht.

Da während der kurzen Periodendauern t2...t4 der erste und der dritte Umschalter u1, u3 sich in der in Fig. 4 gezeigten Position befinden, andererseits der Umschalter u4 während der Periodendauern t1, t2 sich in der nicht gezeichneten Position befindet und schließlich der Umschalter u2 sich während der Periodendauern t1...t3 in der gezeichneten Position befindet, gelangt während der Periodendauer t1 das Digitalwort e1 an den Eingang der Verzögerungsstufe vs2 und zu Beginn der Periodendauer t2 an deren Ausgang und somit an den einen Eingang der Addierers ad, an dessen anderen Eingang zu Beginn der Periodenauer t2 das Digitalwort e2 gelangt. Am Ausgang des Addierers ad entsteht somit das Digitalwort e1 + e2 = 1s2, das zu Beginn der Periodendauer t3, von der Verzögerungsstufe vs3 verzögert, an den einen Addierereingang gelangt, zu welchem Zeitpunkt am anderen Eingang das Digitalwort e3 ansteht. Am Ausgang wird somit das Digitalwort 1s3 gebildet, das zu Beginn der Periodendauer t4 an den einen Addierereingang gelangt, zu welchem Zeitpunkt am anderen Addierereingang das Digitalwort e4 ansteht. Am Addiererausgang ergibt sich dann während der Periodendauer t4 das Digitalwort 1s4.

Dieses gelangt nun, da sich der Umschalter u3 während der Periodenauer t4 in der nichtgezeichneten Position befindet, an den Eingang der Verzögerungsstufe v1' und nach drei Periodendauern, also zu Beginn der Periodendauer t8, an den Minuend-Eingang des Subtrahierers ms', zu welchem Zeitpunkt an dessen Subtrahend-Eingang das Digitalwort e8 ansteht. Somit ergibt sich an dessen Ausgang die Differenz 1s4-e8 = k1.

Dieses Digitalwort k1 wird während der nächsten drei Periodendauern t9...t11 in den drei Verzögerern v'1...v'n-1 verzögert und liegt somit zu Beginn der Periodendauer t11 am Minuend-Eingang des Subtrahierers ms', an dessen Subtrahend-Eingang zum selben Zeitpunkt aus dem Festwertspeicher r' das Digitalwort e11 gelangt, da der dritte Umschalter u3 sich während der Periodendauer t9 in der gezeichneten Stellung befindet. Am Ausgang des Subtrahierers ms' ergibt sich während der Periodendauer t11 das Digitalwort k2 = k1-e11, das wiederum zum Eingang der drei Verzögerer v'1...v'1n-1 gelangt, da während der Periodendauer t11 der Umschalter u3 in der gezeichneten Stellung sich befindet. Während der Periodendauer t14 liegt das Digitalwort k2 somit am Minuend-Eingang des Subtrahierers ms' und zum selben Zeitpunkt an dessen Subtrahend-Eingang das Digitalwort e14. Am Ausgang des Subtrahierers ms' entsteht somit das Digitalwort k3 = k2-e14. Auch dieses wird wieder über die drei Verzögerer v'1...v'n-1 geschickt und steht während der Periodendauer t17 am Minuend-Eingang des Subtrahierers ms'. Zugleich liegt an dessen Subtrahend-Eingang das Digitalwort e17, so daß an dessen Ausgang das Digitalwort k4 = k3-e17 gebildet wird.

Dieses Digitalwort k4 wird nun in der ersten Verzögerungsstufe vs1 um drei kurze Periodendauern verzögert und im Konstantendividierer beispielsweise durch 8 dividiert, so daß es als (k4)/8 zu Beginn der Periodendauer t20 am zweiten Eingang des Umschalters u2 liegt, während der er in die nichtgezeichnete Schaltstellung umschaltet, da er vom Hilfstaktsignal f4 gesteuert ist. Während der nächsten Periodendauer t21 wird das Digitalwort (k4)/8 durch die Verzögerungsstufe vs2 um eine kurze Periodendauer verzögert und liegt somit zu Beginn der Periodendauer t22 am einen Eingang des Addierers ad, an dessen anderen Eingang über den Umschalter u1, der nun ebenfalls in der nichtgezeichneten Schaltstellung liegt, das Digitalwort i5 gelangt, das während der Periodendauer t20 gerade am Ausgang m4 des Verzögerers v8 auftritt.

Während der Periodendauer t21 wird das Schaltglied sw vom Hilfstaktsignal f1 leitend gesteuert und das Endergebnis (k4)/8 + i15 vom Ausgang des Addierers ad zum Ausgang ag des Digitalfilters durchgeschaltet.

Wie die Fig. 8a und b zeigen, laufen während jeder der langen Periodendauern T5...T10 innerhalb der zweiten bis vierten kurzen Periodendauern die zu den Digitalworten e... und den daraus gebildeten Differenzen ...s... führenden Subtraktionen ab. Wie bereits erläutert, läuft zeitlich parallel hierzu die Bildung der Digitalwörter k.... in den Verzögerern v'1...v'n-1 und dem Subtrahierer ms' ab. Jeweils in einer ersten kurzen Periodendauer innerhalb einer langen Periodendauer wird der Addierer ad zur Bildung eines Endergebnis-Digitalwortsherangezogen. Bei den Fig. 8a und b ist in der Zeile aa, die also das Ausgangssignal des Addierers ad angibt, erst in der Periodendauer T10 ein Ergebnis vorhanden, da wie vorausgesetzt die Funktionserläuterung von einem Nullzustand ausgeht.

Die Signalverarbeitung im Digitalfilter nach der Erfindung geschieht in Parallelform, d.h. die einzelnen Stellen der Digitalwörter werden gleichzeitig verarbeitet, wobei allerdings vom sogenannten Pipelining wenn nötig Gebrauch gemacht ist.

Das Digitalfilter der Erfindung läßt sich ohne weiteres in Form von integrierten Halbleiterschaltungen realisieren, wobei insbesondere die Anwendung der Technik der Isolierschicht-Feldeffekt-Transistorschaltungen, also die sogenannte MOS-Technik, von Vorteil ist.

Mittels der Wahl der Funktion e = bd, insbesondere der Abhängigkeit b von d, läßt sich die Adaptivität beeinflussen. Mit der in Fig. 3 gezeigten qualitativen Abhängigkeit b von d ergibt sich ein Tiefpaßverhalten.

Das Digitalfilter nach der Erfindung ist mit Vorteil in digitalen Fernsehempfängerschaltungen, insbesondere der SECAM-Norm, aber auch in digitalen Schaltungen von Videorecordern verwendbar.

## Ansprüche

1. Nichtrekursives Digitalfilter mit einer im Signalweg liegenden Serienschaltung einer geraden Anzahl (2n) von gleichen Verzögerern (v...), deren Verzögerungszeit jeweils gleich der Periodendauer des Taktsignals (ts) des Digitalfilters oder einem Vielfachen davon ist, und mit einem Addierer (ad), dessen Ausgang des Filterausgang (ag) ist, gekennzeichnet durch folgende Merkmale:
   - jedem Verzögerer ist ein Subtrahierer (s...) und ein Festwertspeicher (r...) zugeordnet,
   - der jeweilige Minuend-Eingang der Subtrahierer (s...) liegt am Eingang des zugeordneten Verzögerers der ersten Hälfte der Verzögerer (v1, vn) bzw. am Ausgang des zugeordneten Verzögerers der zweiten Hälfte der Verzögerer (vn + 1, v2n), während der Subtrahend-Eingang aller Subtrahierer (s...) gemeinsam mit dem Mittelpunkt (mp) der Verzögerer-Serienschaltung und mit dem ersten Eingang des Addierers (ad) verbunden sind,
   - der jeweilige Ausgang der Subtrahierer (s...) liegt am Adreßeingang des zugeordneten Festwertspeichers (r...),
   - der jeweilige Ausgang der Festwertspeicher (r...) ist mit einem entsprechenden Eingang eines Mehrfachaddierers (ma) verbunden, dessen Ausgang am zweiten Eingang des Addierers (ad) liegt, und
   - in jedem Festwertspeicher (r...) ist die Funktion e = bd gespeichert wobei mit d das Ausgangssignal des zugehörigen Subtrahierers (s...) und mit b ein von der Differenz zwischen dem Signalwert am Mittelpunkt (mp) und dem Eingangssignalwert des jeweiligen Verzögerers der ersten Hälfte (v1, vn) bzw. dem Ausgangssignalwert des jeweiligen Verzögerers der zweiten Hälfte (vn + 1, v2n) abhängiger Wert bezeichnet ist.

2. Digitalfilter nach Anspruch 1 für den Fall, daß die erste Hälfte der Festwertspeicher (r1, rn) spiegelsymmetrisch zur zweiten Hälfte der Festwertspeicher (rn + 1, r2n) ist, gekennzeichnet durch folgende Merkmale:
   - die jeweils zweite Hälfte der Verzögerer, Subtrahierer und Festwertspeicher (vn + 1, v2n; sn + 1, s2n; rn + 1, r2n) entfällt,
   - der Mehrfachaddierer ist dadurch als Mehrfachaddierer/subtrahierer (ms) ausgebildet, daß die den entfallenen Festwertspeichern (rn + 1, r2n) zugeordneten Addend-Eingänge in Subtrahend-Eingänge umgewandelt sind,
   - jedem verbliebenen Festwertspeicher (r1, rn) ist jeweils ein Zusatzverzögerer (z1, zn) zugeordnet, dessen Eingang am Ausgang des zugehörigen Festwertspeichers (r1, rn) und dessen Ausgang am jeweiligen Subtrahend-Eingang des Mehrfachaddierers/Subtrahierers (ms) liegt, und
   - die Verzögerungszeit des signaleingangsseitigen Zusatz-Verzögerers (z1) ist das n-fache der Periodendauer des Taktsignals, die des folgenden Zusatzverzögerers das (n-1)fache der Periodendauer etc., wobei n die reduzierte Anzahl der Verzögerer (v1, vn) ist.

3. Digitalfilter nach Anspruch 1 für den Fall, daß in die erste Hälfte der Festwertspeicher (r1, rn) spiegelsymmetrisch zur zweiten Hälfte der Festwertspeicher (rn + 1, r2n) ist und die Datenrate der zu filternden Digitalsignale gleich dem n-ten , insbesondere vierten, Teil der Frequenz des Taktsignals (ts) ist, gekennzeichnet, durch folgende Merkmale:
   - die jeweils erste Hälfte der Verzögerer, Subtrahierer und Festwertspeicher (v1, vn; s1, sn; r1, rn) entfällt,
   - die jeweilige Verzögerungszeit der Verzögerer (v5, v6, v7, v8) der zweiten Hälfte ist gleich der n-fachen, insbesondere vierfachen, Periodendauer des Taktsignals (ts),

- von den eigentlich jeweils n Subtrahierern und Festwertspeichern sind nur ein Subtrahierer (s'), ein Festwertspeicher (r') und ein weiterer Subtrahierer (ms') vorhanden, die innerhalb der Periodendauer der Datenrate zeitlich nacheinander n mal , insbesondere viermal, benutzt sind, wobei der Addierer (ad) mit dem weiteren Subtrahierer (ms') während n-1, insbesondere drei, Periodendauern des Taktsignals (ts) als Mehrfachaddierer/subtrahierer zusammenwirkt,

- der jeweilige Ausgang der Verzögerer (v5...v8) liegt am Minuend-Eingang des Subtrahierers (s') über ein jeweiliges Schaltglied (sg5...sg8), dessen jeweiligem Steuereingang ein n-tes, insbesondere viertes, bzw. ein (n-1)tes... bzw. erstes Hilfstaktsignal (f4...f1) zugeführt ist.
  - dessen Frequenz gleich dem n-ten, insbesondere vierten, Teil der Frequenz des Taktsignals (ts) ist,
  - dessen Impulsbreite gleich der Periodendauer des Taktsignals ist,
  - dessen Impulse jeweils um diese Periodendauer versetzt aufeinanderfolgen und
  - das während seines H-Pegels das jeweilige Schaltglied (sg5...sg89 leitend steuert,

- der Ausgang des Festwertspeichers (r') liegt auch am jeweils ersten Eingang eines ersten und eines zweiten Umschalters (u1, u2),

- der Ausgang des letzten Verzögerers (v8) liegt am zweiten Eingang des ersten Umschalters (u1), dessen Ausgang mit dem ersten Eingang des Addierers (ad) verbunden ist,

- dessen Ausgang liegt am ersten Eingang eines dritten Umschalters (u3), dessen Ausgang mit dem Eingang einer Serienschaltung von n-1 weiteren Verzögerern (v'1, v'n-1) verbunden ist, und erst über ein weiteres Schaltglied (sw) am Ausgang (ag),

- der Ausgang des letzten weiteren Verzögerers (v'n-1) liegt am Minuend-Eingang des weiteren Subtrahierers (ms'), dessen Ausgang am zweiten Eingang des dritten Umschalters (u3) angeschlossen ist,

- dieser zweite Eingang liegt ferner in dieser Reihenfolge über eine erste Verzögerungsstufe (vs1) und einen Konstantendividierer (kd) am zweiten Eingang des zweiten Umschalters (us2), dessen Ausgang über eine zweiten Verzögerungsstufe (vs2) mit dem ersten Eingang eines vierten Umschalters (u4) verbunden ist,

- der zweite Eingang bzw. der Ausgang des vierten Umschalters (u4) ist über eine dritte Verzögerungsstufe (vs3) mit dem Ausgang bzw. mit dem zweiten Eingang des Addierers (ad) verbunden,

- die Verzögerungzeit der ersten Verzögerungsstufe (v1) ist gleich der (n-1)-fachen, insbesondere dreifachen, Periodendauer des Taktsignals (ts),

- die jeweilige Verzögerungzeit der zweiten und dritten Verzögerungsstufe (vs2, vs3) sowie der n-1 weiteren Verzögerungsstufen (v'1... v'n-1) ist gleich der Periodendauer des Taktsignals (ts),

- dem jeweiligen Steuereingang des ersten Umschalters (u1) und des weiteren Schaltglieds (sw) ist das erste Hilfstaktsignal (f1) zugeführt,

- am jeweiligen Steuereingang des zweiten und des dritten Umschalters (u2, u3) liegt das n-te, insbesondere vierte, Hilfstaktsignal (f4) und an dem des vierten Umschalters (u4) ein weiteres Hilfstaktsignal (f5) mit dem Puls-Pausen-Verhältnis 1:1 und einer Frequenz, die gleich dem n-ten, insbesondere vierten, Teil der Frequenz des Taktsignals (ts) ist, und

- während des jeweiligen H-Pegels des ersten und vierten sowie des weiteren Hilfstaktsignals (f1, f4, f5) ist der jeweilige Ausgang
  - beim ersten , dritten und vierten Umschalter (u1, u3, u4) mit seinem ersten Eingang,
  - beim zweiten Umschalter (u2) mit seinem zweiten Eingang und
  - beim weiteren Schaltglied (sw) mit seinem Eingang durchverbunden.

## Claims

1. Nonrecursive digital filter comprising a series combination of a number (2n) of like delay elements (v...) in the signal path each providing a delay equal to the period of the clock signal (ts) of the digital filter or to a multiple thereof, and an adder (ad) whose output is the filter output (ag),
   characterized by the following features:
   - Each of the delay elements has a subtracter (s...) and a read-only memory (r...) associated therewith;
   - the minuend inputs of the subtracters (s...) are connected to the inputs of the associated delay elements of the first half of the delay elements (v1, vn) and to the outputs of the associated delay elements of the second half of the delay elements (vn + 1 , v2n), respectively, while the subtrahend inputs of all subtracters (s...) are connected to the center tap (mp) of the series combination of delay elements and to the first input of the adder (ad);
- the output of each of the subtracters (s...) is coupled to the address input of the associated read-only memory (r...);
- the output of each of the read-only memories (r. ..) is connected to one of the inputs of a multiple-input adder (ma) having its output connected to the second input of the adder (ad), and
- each read-only memory (r...)- contains the function e = bd, where d is the output signal of the associated subtracter (s...), and b is a value dependent on the difference between the signal value at the center tap (mp) and the input-signal value of the respective delay element of the first half (v1, vn) or the output-signal value of the respective delay element of the second half (vn + 1, v2n).

2. A digital filter as claimed in claim 1 for the case where the first half of the read-only memories (r1, rn is symmetrical with respect to the second half of the read-only memories (rn + 1, r2n), characterized by the following features:
- The second half of the delay elements (vn + 1), v2n), the second half of the subtracters (sn + 1, s2n), and the second half of the read-only memories (rn + 1, e2n) are omitted;
- the multiple-input adder is designed as a multiple-in-put adder/subtracter (ms) by converting the addend inputs associated with the omitted read-only memories (rn + 1, r2n) into subtrahend inputs;
- each of the remaining read-only memories (r1, rn) has an additional delay element (z1', zn) associated therewith which has its input connected to the output of the associated read-only memory (r1, rn) and whose output is fed to the associated subtrahend input of the multiple-input adder/subtracter (ms), and
- the delay produced by the additional delay element (z1) located at the signal-input end is equal to n times the period of the clock signal, that produced by the following additional delay element is equal to n-1 times the period, etc., where n is the reduced number of delay elements (v1, vn).

3. A digital filter as claimed in claim 1,for the case where the first half of the read-only memories (r1, rn) is symmetrical with respect to the second half of the read-only memories (rn + 1, r2n), and where the data rate of the digital signals to be filtered is equal to one nth, preferably one fourth, of the frequency of the clock signal (ts), characterized by the following features:
- The first half of the delay elements (v1, vn)- the first half of the subtracters (s1, sn), and the first half of the read-only memories (r1, rn) are omitted;
- the delay provided by each of the delay elements (v5, v6, v7, v8) of the second half is equal to n times, preferably four times, the period of the clock signal (ts);
- of the n subtracters and n read-only memories, only one subtracter (s'), one read-only memory (r'), and one additional subtracter (ms') are present which are used n times, preferably four times, in succession within the period corresponding to the data rate, the adder (ad) cooperating with the additional subtracter (ms') during n-1, preferably three, periods of the clock signal (ts) to perform the function of a multiple-input adder/subtracter;
- the outputs of the delay elements (v5...v8) are applied to the minuend input of the subtracter (s') through associated switching devices (sg5... sg8) whose control inputs are supplied with an nth, preferably fourth, auxiliary clock signal (f4), an (n-1)st auxiliary clock signal (f3), ..., and a first auxiliary clock signal (f1) , respectively,
  - whose frequencies are equal to n times, preferably four times, the frequency of the clock signal (ts),
  - whose pulse width is equal to the period of the clock signal,
  - whose pulses follow one after the other and are displaced in relation to one another by said period, and
  - which switch the respective switching devices (sg5 ... sg8) to the conducting state during their H level;
- the output of the read-only memory (r') is also coupled to the first inputs of a first switch (u1) and a second switch (u2);
- the output of the last delay element (v8) is coupled to the second input of the first switch (u1), whose output is connected to the first input of the adder (ad);

- the output of the adder is coupled to the first input of a third switch (u3), whose output is connected to the input of a series combination of n-1 additional delay elements (v'1, v'n-1), and through an additional switching device (sw) to the output (ag) of the digital filter;
- the output of the last additional delay element (v'n-1) is coupled to the minuend input of the additional subtracter (ms'), which has its output connected to the second input of the third switch (u3);
- this second input is also connected through a first delay stage (vs1) and a constant divider (kd) to the second input of the second switch (us2), whose output is connected to the first input of a fourth switch (u4) through a second delay stage (vs2);
- the second input and the output of the fourth switch (u4) are connected to the output of the adder (ad) through a third delay stage (vs3) and to the second input of the adder (ad), respectively;
- the delay provided by the first delay stage (v1) is equal to n-1 times, preferably three times, the period of the clock signal (ts);
- the delay provided by each of the second and third delay stages (vs2, vs3) and the n-1 additional delay stages (v'1 . . .v'n-1) is equal to the period of the clock signal (ts);
- the control inputs of the first switch (u1) and the additional switching device (sw) are fed with the first auxiliary clock signal (f1);
- the control inputs of the second and third switches (u2, u3) are fed with the nth, preferably the fourth, auxiliary clock signal (f4), and that the fourth switch (u4) is fed with an additional auxiliary clock signal (f5) having a 1:1 mark/space ratio and a frequency equal to one nth, preferably one fourth, of the frequency of the clock signal (ts), and
- during the H levels of the first and fourth auxiliary clock signals (fl, f4) and of the additional auxiliary clock signal (f5),
  - the outputs of the first, third, and fourth switches (u1, u3, u4) are connected to the first input of the respective switch,
  - the output of the second switch (u2) is connected to the second input of this switch, and
- the output of the additional switching device (sw) is connected to the input of this device.

**Revendications**

1. Filtre numérique non récursif comportant un circuit série, situé dans la voie de transmission des signaux et formé par un nombre (2n) de circuits identiques de retardement (v...), qui produisent un retard égal respectivement à la durée de la période du signal de cadence (ts) du filtre numérique ou à un multiple de cette durée, et un additionneur (ad), dont la sortie constitue la sortie (ag) du filtre,
caractérisé par les caractéristiques suivantes
   - à chaque circuit de retardement sont associés un soustracteur (s...) et une mémoire morte (r...),
   - l'entrée respective de diminuende du soustracteur (s...) est raccordée à l'entrée du circuit associé de retardement faisant partie de la première moitié des circuits de retardement (v1,vn) ou à la sortie du circuit associé de retardement faisant partie de la seconde moitié des circuits de retardement (vn + 1, v2n), tandis que les entrées de nombre à soustraire de tous les soustracteurs (s...) sont raccordées en commun au point central (mp) du circuit série formé par les circuits de retardement et à la première entrée de l'additionneur (ad),
   - la sortie respective des soustracteurs (s...) est raccordée à l'entrée d'adresses de la mémoire morte associée (r...),
   - la sortie respective de la mémoire morte (r. ..) est raccordée à une entrée correspondante d'un additionneur multiple (ma), dont la sortie est raccordée à la seconde entrée de l'additionneur (ad), et
   - la fonction e = bd est mémorisée dans chaque mémoire morte (r...), d désignant le signal de sortie du soustracteur associé (s...) et b une valeur dépendant de la différence entre la valeur du signal présent au niveau du point central (mp) et la valeur du signal d'entrée du circuit de retardement respectif faisant partie de la première moitié (v1,vn) ou la valeur du signal de sortie du circuit de retardement faisant partie de la seconde moitié (vn + 1, v2n).

2. Filtre numérique selon la revendication 1, dans le cas où la première moitié des mémoires mortes (r1, rn) est symétrique de la seconde moitié des mémoires mortes (rn + 1,- r2n), caractérisé par les caractéristiques suivantes:

- la seconde moitié respective des circuits de retardement, des soustracteurs et des mémoires mortes (vn + 1, v2n; sn + 1, s2n; rn + 1, r2n) est supprimée,
- l'additionneur multiple est agencé à la manière d'un additionneur multiple/soustracteur (ms) par le fait que les entrées des nombres à ajouter, associées aux mémoires mortes (rn + 1, r2n) supprimées, sont converties en des entrées de nombres à soustraire,
- à chaque mémoire morte restante (r1,rn) est associée respectivement un circuit supplémentaire de retardement (z1,zn), dont l'entrée est raccordée à la sortie de la mémoire morte associée (r1,rn) et dont la sortie est raccordée à l'entrée respective du nombre à soustraire de l'additionneur multiple/soustracteur (ms), et
- le retard produit par le circuit supplémentaire de retardement (Z1), situé sur le côté de l'entrée des signaux, est égal à n fois la durée de la période du signal de cadence, tandis que le retard produit par le circuit supplémentaire suivant de retardement est égal à (n-1) fois la durée de la période, etc, n étant le nombre réduit des circuits de retardement (v1,vn).

3. Filtre numérique suivant la revendication 1 dans le cas où la première moitié des mémoires mortes (r1, rn) est symétrique de la seconde moitié des mémoires mortes (rn + 1, r2n) et où la cadence des données des signaux numériques devant être filtrée est égale à la n-ème partie, notamment au'quart, de la fréquence du signal de cadence (ts), caractérisé par les caractéristiques suivantes:

- la première moitié respective des circuits de retardement, des soustracteurs et des mémoires mortes (v1, vn; s1,sn; r1,rn) est supprimée,
- le retard respectif produit par les circuits de retardement (v5,v6,v7,v8) de la seconde moitié est égal à n fois, notamment au quadruple, de la durée de la période du signal de cadence (ts),
- parmi les n soustracteurs et mémoires mortes, prévus en propre, il n'existe qu'un soustracteur (s'), qu'une mémoire morte (r') et qu'un autre soustracteur (ms'), utilisés successivement n fois et notamment quatre fois pendant la durée de la période de la cadence des données, l'additionneur (ad) coopérant avec l'autre soustracteur (ms') pendant n-1, notamment trois, durées de la période du signal de cadence (ts), en tant qu'additionneur multiple/soustracteur,

- la sortie respective des circuits de retardement (v5...v8) est raccordée à l'entrée de diminuende du soustracteur (s') par l'intermédiaire d'un autre élément respectif de commutation (sg5. . . sg8), à l'entrée respective de commande duquel est envoyé un n-ème, notamment un quatrième, ou un (n-1)-ème... ou un premier signal de cadence (f4.. . f1),
  - dont la fréquence est égale à la n-ème partie, notamment au quart, de la fréquence du signal de cadence (ts),
  - dont la durée des impulsions est égale à la durée de la période du signal de cadence,
  - dont les impulsions se succèdent en étant respectivement décalées d'une durée de la période, et
  - qui, pendant son niveau H, place à l'état conducteur l'élément de commutation respectif (sg5. . .sg89),
- la sortie de la mémoire morte (r') est également raccordée à la première entrée respective d'un premier et d'un second commutateur (u1,u2),
- la sortie du dernier circuit de retardement (v8) est raccordée à la seconde entrée du premier commutateur (u1), dont la sortie est raccordée à la première entrée de l'additionneur (ad),
- dont la sortie est raccordée à la première entrée d'un troisième commutateur (u3), dont la sortie est raccordée à l'entrée d'un circuit série formé de n-1 autres circuits de retardement (v'1, v'n-1) et, uniquement par un autre circuit de commutation (sw), à la sortie (ag),
- la sortie du dernier autre circuit de retardement (v'n-1) est raccordée à l'entrée de diminuende de l'autre soustracteur (ms'), dont la sortie est raccordée à la seconde entrée du troisième commutateur (u3),
- cette seconde entrée est en outre raccordée, selon cette séquence, au moyen d'un premier étage de raccordement (vs1) et d'un diviseur (kd) réalisant une division par une constante, à la seconde entrée du second commutateur (ts2), dont la sortie est raccordée par l'intermédiaire d'un second étage de retardement (vs2) à la première entrée d'un quatrième commutateur (u4),

- la seconde entrée ou la sortie du quatrième commutateur (u4) est raccordée par l'intermédiaire d'un troisième étage de raccordement (vs3) à la sortie ou à la seconde entrée de l'additionneur (ad),
- le retard produit par le premier étage de retardement (v1) est égal à (n-1) fois, notamment au triple, de la durée de la période du signal de cadence (ts),
- le retard respectif produit par les second et troisième étages de retardement (vs2, vs3) ainsi que par les (n-1) autres étages de retardement (v'1...v'n-1) est égal à la durée de la période du signal de cadence (ts),
- le premier signal de cadence auxiliaire (f1) est envoyé à l'entrée respective de commande du premier commutateur (u1) et de l'autre circuit de commutation (sw),
- le n-ème, notamment le quatrième, signal de cadence auxiliaire (f4) est appliqué à l'entrée respective de commande des second et troisième commutateurs (u2,u3), et un autre signal de cadence auxiliaire (f5) possédant le rapport impulsion/pause entre impulsions 1:1 et une fréquence égale à la n-ème partie, notamment au quart, de la fréquence du signal de cadence (ts), est appliqué à l'entrée respective de commande du quatrième commutateur (u4), et
- pendant le niveau H respectif des premier et quatrième signaux de cadence auxiliaire ainsi que de l'autre signal de cadence auxiliaire (f1,f4,f5), la sortie respective est raccordée directement
  - dans le cas des premier, troisième et quatrième commutateurs (u1,u3,u4), à la première entrée de ces commutateurs,
  - dans le cas du second commutateur (u2), à la seconde entrée de ce commutateur, et
  - dans le cas de l'autre élément de commutation (sw), à l'entrée de cet élément.

# FIG. 1

# FIG. 2

EP 0 255 554 B1

# FIG. 3

# FIG. 4

# FIG. 5

ts a)

f5 b)

i c)

f1 d)

f2 e)

f3 f)

f4 g)

e h)

aa i)

sa j)

da k)

EP 0 255 554 B1

# FIG. 6

|      | T1 | T2 | T3 | T4 | T5 | T6 | T7 | T8 | T9 | T10 | T11 | T12 |
|------|----|----|----|----|----|----|----|----|----|-----|-----|-----|
| eg   | i1 | i2 | i3 | i4 | i5 | i6 | i7 | i8 | i9 | i10 | i11 | i12 |
| m1   |    | i1 | i2 | i3 | i4 | i5 | i6 | i7 | i8 | i9  | i10 | i11 |
| m2   |    |    | i1 | i2 | i3 | i4 | i5 | i6 | i7 | i8  | i9  | i10 |
| m3   |    |    |    | i1 | i2 | i3 | i4 | i5 | i6 | i7  | i8  | i9  |
| m4   |    |    |    |    | i1 | i2 | i3 | i4 | i5 | i6  | i7  | i8  |

# FIG. 7

$$1\,s\,2 = e1 + e2$$
$$1\,s\,3 = e1 + e2 + e3$$
$$1\,s\,4 = e1 + e2 + e3 + e4$$
$$5\,s\,6 = e5 + e6$$
$$5\,s\,7 = e5 + e6 + e7$$
$$5\,s\,8 = e5 + e6 + e7 + e8$$
$$9\,s\,10 = e9 + e10$$
$$9\,s\,11 = e9 + e10 + e11$$
$$9\,s\,12 = e9 + e10 + e11 + e12$$
$$13\,s\,14 = e13 + e14$$
$$13\,s\,15 = e13 + e14 + e15$$
$$13\,s\,16 = e13 + e14 + e15 + e16$$
$$17\,s\,18 = e17 + e18$$
$$17\,s\,19 = e17 + e18 + e19$$
$$17\,s\,20 = e17 + e18 + e19 + e20$$
$$21\,s\,22 = e21 + e22$$

| | | T5 | | | | T6 | | | | T7 | | |
|---|---|---|---|---|---|---|---|---|---|---|---|---|
| | t1 | t2 | t3 | t4 | t5 | t6 | t7 | t8 | t9 | t10 | t11 | t12 |
| m1 | ← | | i4 | → | ← | | i5 | → | ← | | i6 | → |
| m2 | ← | | i3 | → | ← | | i4 | → | ← | | i5 | → |
| m3 | ← | | i2 | → | ← | | i3 | → | ← | | i4 | → |
| m4 | ← | | i1 | → | ← | | i2 | → | ← | | i3 | → |
| a | i1 | | | | i2 | | | | i3 | | | |
| b | | i2 | | | | i3 | | | | i4 | | |
| c | | | i3 | | | | i4 | | | | i5 | |
| d | | | | i4 | | | | i5 | | | | i6 |
| e | i1 –i5 ≙ e1 | i2 –i5 ≙ e2 | i3 –i5 ≙ e3 | i4 –i5 ≙ e4 | i2 –i6 ≙ e5 | i3 –i6 ≙ e6 | i4 –i6 ≙ e7 | i5 –i6 ≙ e8 | i3 –i7 ≙ e9 | i4 –i7 ≙ e10 | i5 –i7 ≙ e11 | i6 –i7 ≙ e12 |
| aa | | 1 s 2 | 1 s 3 | 1 s 4 | | 5 s 6 | 5 s 7 | 5 s 8 | | 9 s 10 | 9 s 11 | 9 s 12 |
| sa | | | | | | | | 1s4–e8 =k1 | | | k1– e11 = k2 | 5s8–e12 =k5 |
| ag | | | | | | | | | | | | |

**FIG. 8a**

| FIG.8a | FIG.8b |
|---|---|

FIG. 8

| | T8 | | | | T9 | | | | T10 | | |
|---|---|---|---|---|---|---|---|---|---|---|---|---|
| | t 13 | t 14 | t 15 | t 16 | t 17 | t 18 | t 19 | t 20 | t 21 | t 22 | t 23 | t 24 |
| m 1 | ← | | i7 | → | ← | | i8 | → | ← | | i9 | → |
| m 2 | ← | | i6 | → | ← | | i7 | → | ← | | i8 | → |
| m 3 | ← | | i5 | → | ← | | i6 | → | ← | | i7 | → |
| m 4 | ← | | i4 | → | ← | | i5 | → | ← | | i6 | → |
| a | i4 | | | | i5 | | | | i6 | | | |
| b | | i5 | | | | i6 | | | | i7 | | |
| c | | | i6 | | | | i7 | | | | i8 | |
| d | | | | i7 | | | | i8 | | | | i9 |
| e | i4 –i8 ≙ e 13 | i5 –i8 ≙ e 14 | i6 –i8 ≙ e 15 | i7 –i8 ≙ e 16 | i5 –i9 ≙ e 17 | i6 –i9 ≙ e 18 | i7 –i9 ≙ e 19 | i8 –i9 ≙ e 20 | i6 –i10 ≙ e 21 | i7 –i10 ≙ e 22 | i8 –i10 ≙ e 23 | i9 –i10 ≙ e 24 |
| aa | | 13 s 14 | 13 s 15 | 13 s 16 | | 17 s 18 | 17 s 19 | 17 s 20 | k4+i 5 | 21 s 22 | | |
| sa | | k2 –e14 = k3 | k5 –e15 = k6 | 9s12 –e16 = k9 | k3 –e17 = k4 | k6 –e18 = k7 | k9 –e19 = k10 | 13s16 –e20 = k13 | k7 –e21 = k8 | k10 –e22 = k11 | k13 –e23 = k14 | 17s20 –e24 = k17 |
| ag | | | | | | | | | (k4)/8+ i15 | | | |

**FIG.8b**

EP 0 255 554 B1